(19) **Europäisches Patentamt / European Patent Office / Office européen des brevets**

(11) **EP 0 972 851 B1**

(12) **EUROPEAN PATENT SPECIFICATION**

(45) Date of publication and mention
of the grant of the patent:
**24.12.2008 Bulletin 2008/52**

(21) Application number: **98961369.0**

(22) Date of filing: **16.12.1998**

(51) Int Cl.:
***C23C 12/00*** (2006.01)

(86) International application number:
**PCT/JP1998/005691**

(87) International publication number:
**WO 1999/031289 (24.06.1999 Gazette 1999/25)**

(54) **SLIDING MEMBER HAVING CHROMIUM NITRIDE FILM FORMED THEREON**

GLEITTEIL MIT DARAUF GEFORMTEN CHROMNITRIDFILM

ELEMENT A GLISSEMENT POURVU D'UN FILM DE NITRURE CHROMIQUE

(84) Designated Contracting States:
**DE GB**

(30) Priority: **16.12.1997 JP 36351597**

(43) Date of publication of application:
**19.01.2000 Bulletin 2000/03**

(73) Proprietor: **Taiho Kogyo Co. Ltd.
Toyota-shi,
Aichi 471-8502 (JP)**

(72) Inventors:
• **FUJII, Sachiko-Taiho Kogyo Co., Ltd.
Aichi-ken 471-8502 (JP)**
• **MIZUGUCHI, Shinichi-Taiho Kogyo Co., Ltd.
Aichi-ken 471-8502 (JP)**

• **HONG, Soo-Myung-Taiho Kogyo Co., Ltd.
Aichi-ken 471-8502 (JP)**
• **TACHIKAWA, Hideo-Kabushiki Kaisha Toyota
Chuo Kenk
Aichi-gun,Aichi-ken 480-1192 (JP)**
• **NAKANISHI, Kazuyuki-Kabushiki Kaisha Toyota
Chuo K
Aichi-gun,Aichi-ken 480-1192 (JP)**

(74) Representative: **Higgs, Jonathan et al
Urquhart-Dykes & Lord LLP
30 Welbeck Street
London W1G 8ER (GB)**

(56) References cited:
**EP-A- 0 702 097    JP-A- 6 287 743
JP-A- 8 296 030    JP-B2- 2 584 217
US-A- 5 077 091**

EP 0 972 851 B1

**Description**

Technical Field

The present invention relates to a sliding member with a chromium nitride film formed, more specifically speaking, it relates to a sliding member whose wear resistance is remarkably improved by a noble combination of a crystalline structure of chromium nitride and a crystalline orientation thereof.

Background Art

To use chromium nitride as a film of a sliding member is know in Japanese Unexamined Patent Publication (KOKAI) No. 64-63,692, for example. In this publication, there is disclosed to form a chromium nitride layer on surfaces of a vane, a roller and a shaft of a rotary compressor by ion plating or metallizing.

In Japanese Unexamined Patent Publication (KOKAI) No. 2-129,360, there is disclosed a steel material on which a CrN film whose (220) plane exhibits the maximum diffraction intensity is formed by an ion plating method.

Similarly, in Japanese Unexamined Patent Publication (KOKAI) No. 2-175,858 and Japanese Unexamined Patent Publication (KOKAI) No. 2-175,858, there are disclosed a steel material on which a film whose (220) plane exhibits the maximum diffraction intensity and which includes a precipitation phase of a CrN single phase is formed by an ion plating method. Here, by adjusting the ion plating conditions, the precipitation of Cr and $Cr_2N$ is suppressed, and the precipitation phase of the CrN single phase is produced, thereby making the wear resistance superb.

Moreover, Japanese Unexamined Patent Publication (KOKAI) No. 7-189,955 proposes to form a film of chromium carbide and nitride on sliding component parts of a rotary type compressor by ion plating.

As described above, in chromium nitride films formed by conventional ion plating the sliding characteristics of the CrN structure are favorable, but the sliding characteristics of $Cr_2N$ are not good. In addition, in a research paper (Proc., Int. Compressor Eng. Conf., Purdue (1996) 257 WEAR CHARACTERISTICS OF EACH COMPOSITION THE CHROMIUM NITRIDED COATED VANE IN TFE ROTARY COMPRESSOR FOR HFC-134a) on the wear characteristics of chromium nitride which is formed by PVD (Physical vapor deposition), there is similarly described that $Cr_2N$ is poorer than CrN in terms of the sliding characteristics.

Not on a sliding member, but on molds, jigs and mechanical component parts, forming chromium nitride by a fluidized-layer-furnace technique is disclosed in Patent No. 2,584,217 (issued on February 26, the 9th year of Heisei (1997)). In this patent publication, the chromium nitride is identified as CrN by an X-ray diffraction, and, in addition to the chromium nitride iron nitrides are formed.

As described above, it has been known that the CrN film, which is formed by the conventional PVD method or ion plating method, is used for sliding members of rotary compressors, because of this film, the sliding characteristics are improved more remarkably than conventional surface hardening treatments. However, according to the studies of the present inventors, it was found out that the CrN film causes agglutination microscopically to develop wear when it slides with an iron alloy in the mating member or when the films slide with each other.

Especially, in sliding under mixing-boundary lubricating conditions, since the sliding surfaces of component parts contact with the irregular portions of the mating member at the superficial films, there arises a problem in that the agglutination is likely to develop, and accordingly it is necessary to further improve the wear resistance as the component parts of the rotary compressors, etc.

Disclosure of Invention

In the conventional chromium nitride film, it is an established theory that $Cr_2N$ is inferior to CrN in terms of the sliding characteristics, however, the present inventors discovered that, by making a sliding surface into a specific crystalline orientation plane of $Cr_2N$, the sliding characteristics are better improved than CrN, and thus completed the present invention.

Namely, the present invention is to provide a sliding member with a chromium nitride film according to claim 1 wherein a sliding member is provided with a chromium nitride film formed on a sliding surface of a substrate wherein said chromium nitride has a $Cr_2N$ structure and its sliding surface is substantially parallel to a (002) plane of said $Cr_2N$.

Brief Description of Drawings

Fig. 1 is an X-ray diffraction chart of a $Cr_2N$ powder.
Fig. 2 is an X-ray diffraction chart of a (002)-oriented $Cr_2N$ film according to Example No. 1.

Fig. 3 is a diagram for illustrating a unit lattice of hexagonal $Cr_2N$.

Fig. 4 is a microscopic photograph (magnification x 3,000) on a metallic structure for illustrating a lamellar structure of the (002)-oriented $Cr_2N$ film according to Example No. 1.

Fig. 5 is a diagram for illustrating a wear resistance testing method.

Fig. 6 is a graph for illustrating the results of the wear resistance test.

Fig. 7 is an X-ray diffraction chart of $Cr_2N$, which is not (002)-oriented, according to a PVD method.

Fig. 8 is a diagram for illustrating a wear resistance testing method.

Fig. 9 is a graph for illustrating the results of the wear resistance test.

Fig. 10 is a photograph, which is similar to Fig. 4, on SKD61 having a carbon content of 0.4% in Example No.3.

Fig. 11 is a diagram for illustrating types of substrates, carbon contents, processing times and adhesions in Example No.3, and film thicknesses as a bar graph.

<u>Detailed Description of Invention</u>

Hereinafter, the present invention will be described in detail.

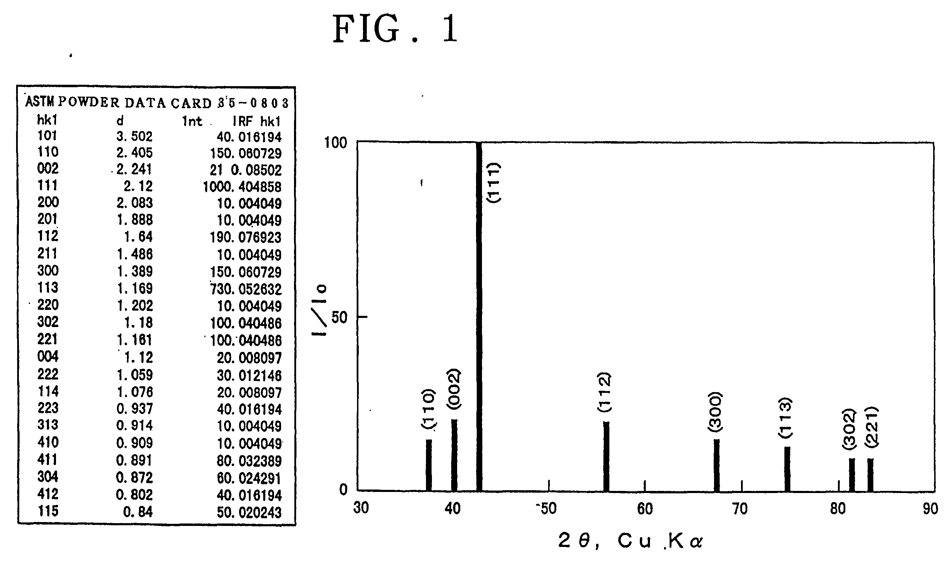

First, the physical properties of $Cr_2N$ will be described. $Cr_2N$ has a hexagonal structure. The X-ray diffraction chart (ASTM powder data card 35-0803) of a $Cr_2N$ powder is shown in Fig. 1.

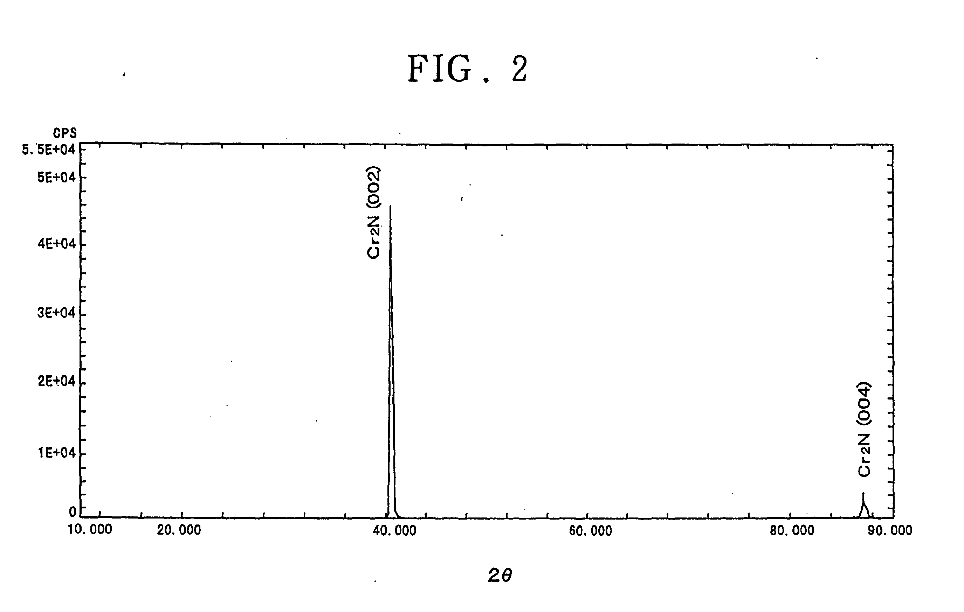

The X-ray diffraction chart (measuring conditions: Cu tube bulb; tube voltage 30 kV; and tube current 150 mA) of a $Cr_2N$ film according to an example of the present invention is shown in Fig. 2. Comparing Fig. 1 with Fig. 2, peaks, such as (111), (110), (112), (300) and (113), observed in Fig. 1 disappear in Fig. 2, and, in Fig. 2, the (002) peak at about 40 deg. is strong, and the (004) peak is slightly appreciated. Therefore, the film of Fig. 2 is strongly oriented to (002).

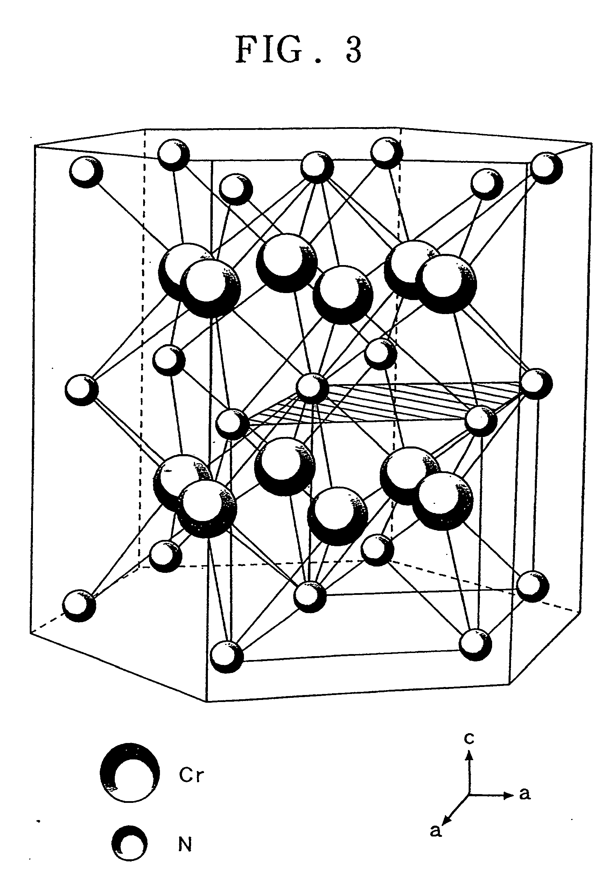

In the $Cr_2N$ film in which the (002) plane of the hexagonal system is oriented parallelly to a sliding surface, sliding occurs in directions within the (002) plane in which the Cr atom plane and the N atom plane are laminated alternately (See Fig. 3.). On the other hand, in the conventional-technique (220)-oriented CrN, since sliding occurs in directions within the (220) plane of the cubic system in which the Cr atoms and the N atoms coexist, the sliding surface of the atoms differs from that of the present invention. Since there is such a difference, in the present invention, it is considered that the Cr and N of the sliding surface are likely to slide, and accordingly that the agglutination and the wear are less likely to occur.

In the present invention, the (002)-plane orientation means that the peak intensity of the (002) peak, which is parallel to the sliding surface, is higher than the other index peaks, further preferably $X_{002}$ obtained by the following equation falls in the range of from 40 to 100%, furthermore preferably in the range of from 60 to 100%.

$$X_{002} = \{(IF_{002} - 0.103)/0.897\} \times 100$$

wherein

$$IF_{002} = I_{002}/(I_{110} + I_{002} + I_{111} + I_{112} + I_{300} + I_{113} + I_{302} + I_{221}),$$

and $I_{hkl}$ is the X-ray diffraction intensity.

The $Cr_2N$ film in the present invention is one whose $Cr_2N$ structure can be identified in the surface of the film by the X-ray diffraction carried out under the conditions described with reference to Fig. 2. As far as this structure can be identified, elements other than Cr, N and C, for example, Fe, O, etc., can be solved in $Cr_2N$ in small amounts. It is preferred that metallic chromium other than $Cr_2N$ is not present. In the present invention, the film of $Cr_2N$ preferably has a thickness of from 1 to 30 $\mu$m, further preferably from 3 to 15 $\mu$m.

The substrate in the present invention can employ iron, carbon steel, alloy steel, cast iron, and sintered materials of these. Moreover, by nitriding the surfaces of these materials in advance, it is possible to supply the nitrogen of $Cr_2N$ from the substrate side.

Subsequently, a production process of the $Cr_2N$ film whose sliding surface is (002)-oriented will be described.

The present inventors succeeded in producing the (002)-oriented $Cr_2N$ by adjusting the reaction temperature to 800 to 1,000 °C in the fluidized-layer-furnace method disclosed in aforementioned Patent No. 2,584,217. However, the formation of the (002)-oriented $Cr_2N$ can be carried out not by said fluidized-layer-furnace method, but by a powder-packing method or a PVD method.

Moreover, when the substrate of the sliding member comprises a steel material, the chromium nitride film can substantially comprise Cr, N and C. Namely, when the carbon content of the steel material is large, the carbon of the steel material is retrieved into the film during the formation of the chromium nitride film, but the film maintains the $Cr_2N$ structure without precipitating the carbon, or as later described the carbon precipitates as chromium carbides between the $Cr_2N$ and the steel substrate. The carbon in the $Cr_2N$ increases the hardness of the film, thereby making the sliding characteristics further favorable. In the present invention, the composition of the chromium nitride film can preferably comprise 5.5-17.5% by weight of N, 0.5-6.5% by weight of C, and the balance of Cr.

In the present invention, by intervening chromium carbide between the chromium nitride film and the substrate in a lamellar manner or a particulate manner, the adhesion of the chromium nitride film can be enhanced. The formation of the chromium carbide can be controlled by the processing conditions and the carbon content of the substrate.

Effect of Invention

The sliding member of the present invention has a characteristic in that it is less likely to wear under the mixing-boundary lubricating conditions where the effect of a lubricating oil is not fully expected and the wear is likely to occur by the agglutination between sliding members. Therefore, the sliding member of the present invention can be utilized in transportation component parts, air-conditioning component parts, mechanical component parts, etc., which are required to effect wear resistance under the mixing-boundary conditions. The reason why the good sliding characteristics are obtained is assumed as follows. Since the Cr atom plane and the N atom plane are laminated alternately in the (002) direction of the hexagonal $Cr_2N$ structure (See Fig. 3.), the sliding surface agrees with the (002) plane when the hexagonal $Cr_2N$ is oriented to the (002) plane on the sliding surface, and the agglutination with the mating member is less likely to occur when the sliding surface becomes the N atom plane, if the agglutination occurs on the Cr atom plane, the sliding is likely to occur between the N/Cr atom planes, and accordingly considerable agglutination is less likely to occur.

Best Mode for Carrying Out the Invention

Hereinafter, the present invention will be described in further detail with reference to specific examples.

Example No.1

A pin (diameter 6 mm, surface roughness 0.8 $\mu$m Rz) made from a hot-working die steel (SKD61) was nitrided and was utilized as a substrate, and a fluidized-layer-furnace reaction was carried out under the following conditions. Note that the nitriding was a gas soft nitriding processing carried out at 580 °C for 4 hours.

    (a) Reaction Temperature: 1,000 °C
    (b) Processing Time: 1 hr.
    (c) Processing Agent: Cr powder (Grain Size #100-150): Alumina Powder (Grain Size #80)
    (d) Reaction Facilitating Agent: $NH_4Cl$ (Supply Amount 8 g/min.)
    (e) Stirring Argon Gas: Flow Rate 4 L/min. · $cm^2$

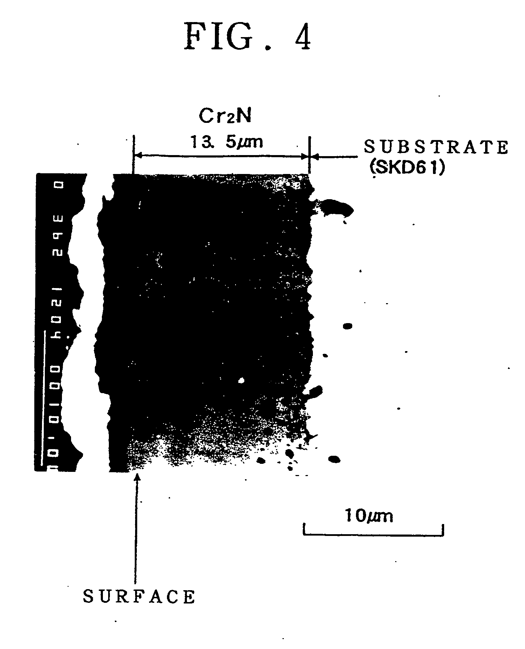

As a result a $Cr_2N$ layer was formed whose structure is shown in Fig. 4 and whose thickness was 13.5 $\mu$m. The X-ray diffraction chart of the $Cr_2N$ is shown in Fig. 2. This analysis chart was obtained by using K$\alpha$ of Cu and by projecting the X-ray onto the surface of the resulting $Cr_2N$ layer at incident angle of 20.15 deg. from the surface. Thus, as illustrated in Fig. 2, the surface was identified to be parallel to the (002) plane. Moreover, the hardness of the $Cr_2N$ film was Hv 145-1,650, and the roughens was 2.0 $\mu$m Rz.

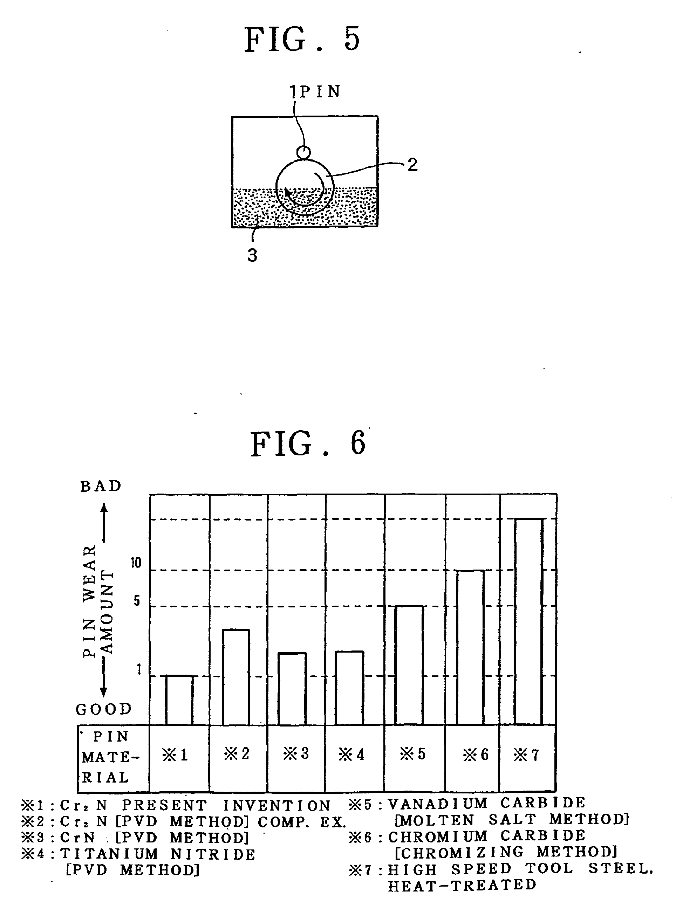

After the SKD61 pin with the $Cr_2N$ film formed was polished to 1.0 $\mu$m Rz by barrel polishing, the SKD61 pin was contacted with a mating ring 2 (FC250 cast iron: roughens 1.0 $\mu$m Rz) with a load of 980 N in an enclosed testing container as illustrated in Fig. 5, the mating member 2, which was immersed by half into a mixture liquid of a coolant and a refrigerator oil, was rotated at a speed of 500 rpm, thereby carrying out a wear test. Under the evaluation conditions, it was estimated from the friction coefficient that the mixing-boundary lubricating conditions were established.

For comparison, the following films were similarly formed on hot-working die steels.

    (i) $Cr_2N$ (formed by a PVD method)
    (ii) Cubic CrN (formed by a PVD method)
    (iii) Cubic TiN (formed by a PVD method)
    (iv) Cubic $V_4C_3$ (formed by a molten salt method)
    (v) $Cr_{23}C_6$, $Cr_7C_3$ (formed by a chromizing method)

Moreover, as a comparative example, a high speed steel (heat-treated SKH51) was made into a pin, and was tested.

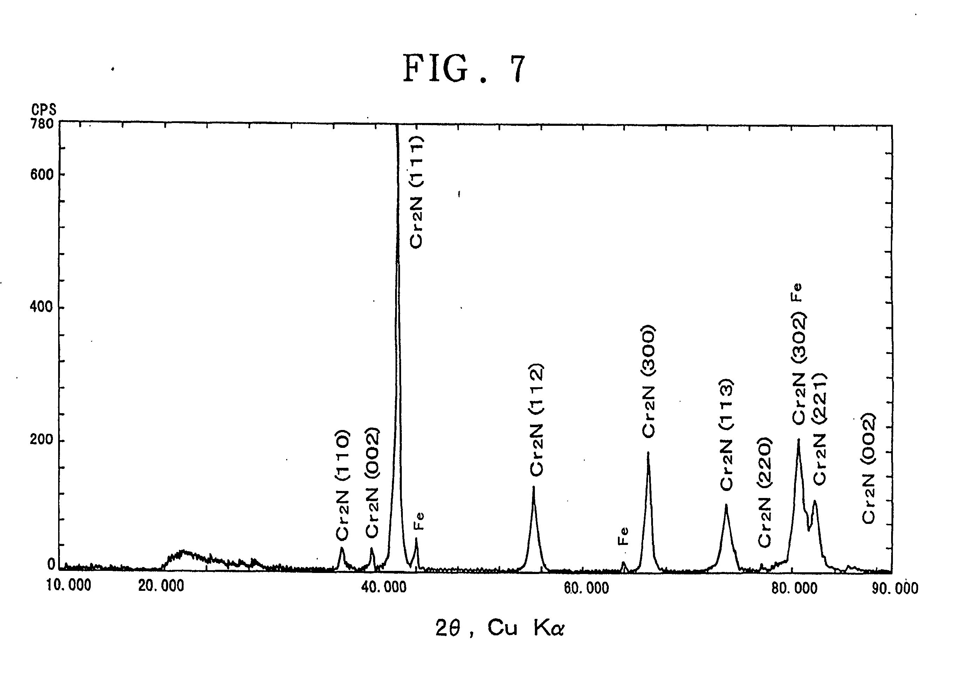

The results of the test are shown in Fig. 6. From Fig. 6, the pin whose sliding surface was formed of the (002)-oriented $Cr_2N$ according to the present invention was worn less. This shows that the wear amount was reduced by half or less than that of the $Cr_2N$ formed by a PVD method which hardly exhibited the orientation (Fig. 7). It is understood that the pin whose sliding surface was formed of the (002)-oriented $Cr_2N$ according to the present invention exhibited the wear amount smaller than any other comparative examples, and particularly that it was better than the PVD-CrN, which has been conventionally said to exhibit the best wear resistance, in terms of the wear resistance.

Example No. 2

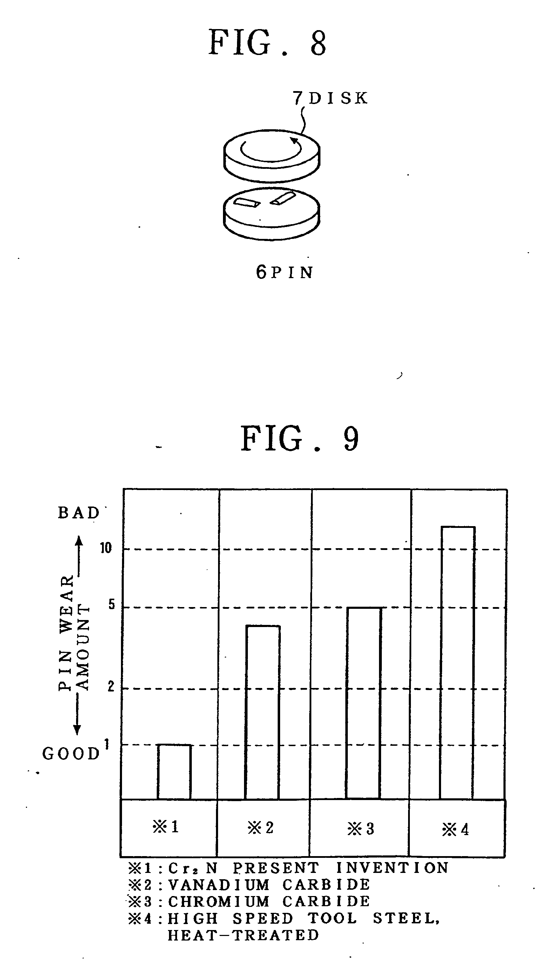

The pins, made from the hot-working die steel and with the $Cr_2N$, the vanadium carbide and the chromium carbide formed, and the pin, made from the heat-treated high speed tool steel, which were tested in Example No. 1, were measured for the wear amounts by a disk/pin type testing method as illustrated in Fig. 8.

In Fig. 8, 6 designates the aforementioned pins, 7 designates a mating disk (FC250 cast iron: roughens 1.0 $\mu$m Rz). The testing conditions were a load of 880 N, a disk revolving speed of 1.0 m/s, and spraying-lubrication with a low-viscosity oil.

In Fig. 9, the test results are illustrated. These results show tendencies similar to Fig. 6.

Example No.3

While the processing conditions in Example 1 were varied as described below and the carbon contents of the substrates were increased or decreased, the fluidized-layer-furnace reaction was carried out. Note that, except SUH35, a steel containing nitrogen, the nitriding process was performed similarly to the SKD61 of Example No. 1.

  (a) Reaction Temperature: 1,000 °C
  (b) Processing Time: 1-4 hrs.
  (c) Processing Agent: Cr powder (Grain Size #100-150): Alumina Powder (Grain Size #80)
  (d) Reaction Facilitating Agent: $NH_4Cl$ (Supply Amount 8 g/min.)
  (e) Stirring Argon Gas: Flow Rate 4 L/min. · $cm^2$

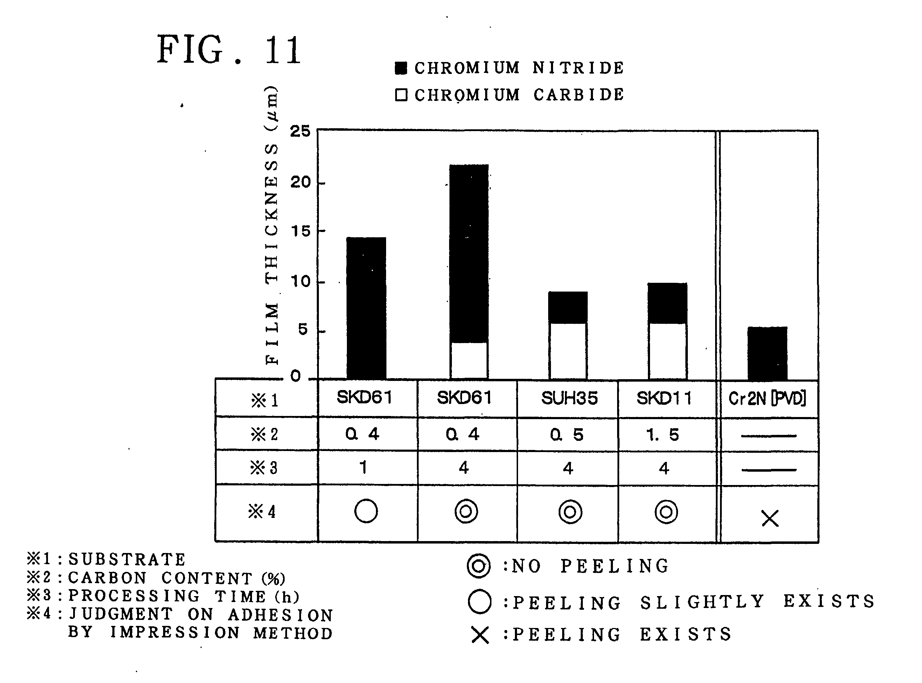

Thereafter, an adhesion test was carried out according to a below-described impression method. The results were judged from the sizes of the cracks generated in the peripheries of the impressions, and are shown in Fig. 11.

In the bar graph of Fig. 11, the blank portions show the film thicknesses of the carbides combined by the C and Cr of the substrates, the solid portions show the film thicknesses of the chromium nitride films. From the results of Fig. 11, it is understood that the adhesion was furthermore favorable when the carbides of chromium intervened between the substrates and the chromium nitride layer. Moreover, in the case where the intervening chromium carbides are distributed in a particulate manner rather than in the case where they are generated in a lamellar manner, the formation speed of the chromium nitride film is higher, and the adhesion of the film is enhanced.

The formation state of the chromium carbides differs greatly depending on the contents of carbon and nitrogen in the iron substrate. In the case where the nitrogen is present in a predetermined amount and the carbon content differs, when the carbon content is small, the formed film exists as a particulate or discontinuous layer in which the chromium carbides are present adjacent to the boundary between the film and the substrate in a particulate or discontinuous manner, when the carbon content is large, it exists as a continuos layer in which the chromium carbides are present between the chromium nitride layer and the substrate in a continuos manner.

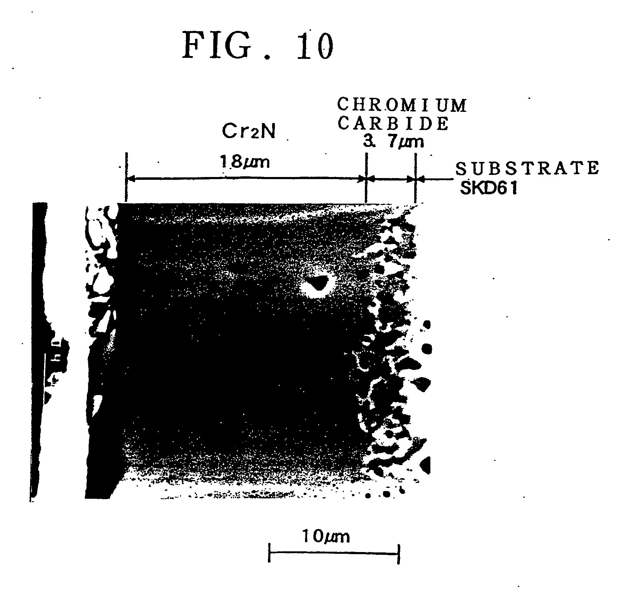

Note that Fig. 10 illustrates a chromium nitride film structure which was obtained when the SKD61 having a carbon content of 0.4% and subjected to the nitriding was processed for 4 hours. This chromium nitride had a $Cr_2N$ structure, too, and its (002) plane was parallel to the surface.

**Claims**

1. A sliding member with a chomium nitride film, said sliding member being provided with the chromium nitride film formed on a sliding surface of a substrate, and said chromium nitride has a $Cr_2N$ structure and a sliding surface being substantially parallel to a (002) plane of the $Cr_2N$ structure,
   wherein the parallelism of the sliding surface with respect to the (002) plane of the $Cr_2N$ structure, which is specified by the following $X_{002}$ being defined by the following equation, falls in the range of from 40 to 100%:

$$X_{002} = \{ ( IF_{002} - 0.103) / 0.897 \} \times 100$$

wherein

$$IF_{002} = I_{002} / ( I_{110} + I_{002} + I_{111} + I_{112} + I_{300} + I_{113} + I_{302} + I_{221}),$$

and $I_{hkl}$ is the X-ray diffraction intensity.

2. The sliding member with a chromium nitride film of Claim 1, said sliding member being **characterised in that** said substrate comprises an iron substrate, and the chromium nitride film substantially comprises Cr, N and C.

3. The sliding member with a chromium nitride film of Claim 2, said sliding member being **characterised in that** said chromium nitride film comprises 5.5-17.5% by weight of N, 0.5-6.5% by weight of C, and the balance of Cr as major components.

4. The sliding member with a chromium nitride film of any of Claims 1 through 3, said sliding member being **characterised in that** chromium carbide intervenes between said chromium nitride film and said substrate in a lamellar manner or a particulate manner.

**Patentansprüche**

1. Gleitelement mit Chromnitridschicht, wobei das Gleitelement mit einer auf der Gleitoberfläche eines Trägermaterials gebildeten Chromnitridschicht bereitgestellt ist und wobei das Chromnitrid eine $Cr_2N$-Struktur hat und die Gleitoberfläche im Wesentlichen parallel zu einer (002)-Ebene der $Cr_2N$-Struktur verläuft,
worin die Parallelität der Gleitoberfläche hinsichtlich der (002)-Ebene der $Cr_2N$-Struktur, die durch das folgende, in der folgenden Gleichung definierte $X_{002}$ spezifiziert wird, in den Bereich von 40 bis 100% fällt:

$$X_{002} = \{(IF_{002} - 0,103) / 0,897\} \times 100,$$

worin

$$IF_{002} = I_{002}/(I_{110} + I_{002} + I_{111} + I_{112} + I_{300} + I_{113} + I_{302} + I_{221} + I_{221})$$

und $I_{hkl}$ die Röntgendiffraktionsintensität ist.

2. Gleitelement mit einer Chromnitridschicht nach Anspruch 1, wobei das Gleitelement
**dadurch gekennzeichnet ist, dass**
das Trägermaterial ein Eisensubstrat und die Chromnitridschicht im Wesentlichen Cr, N und C umfasst.

3. Gleitelement mit einer Chromnitridschicht nach Anspruch 2, worin das Gleitelement
**dadurch gekennzeichnet ist, dass**
die Chromnitridschicht 5,5 bis 17,5 Ges.-% N, 0,5 bis 6,5 Gew.-% C und als Ausgleich Chrom als Hauptelemente enthält.

4. Gleitelement mit einer Chromnitridschicht nach einem der Ansprüche 1 bis 3,
worin das Gleitelement
**dadurch gekennzeichnet ist, dass**
Chromcarbid in schicht- oder teilchenförmiger Weise zwischen der Chromnitridschicht und dem Trägermaterial liegt.

**Revendications**

1.  Organe glissant avec un film de nitrure de chrome, ledit organe glissant étant pourvu d'un film de nitrure de chrome formé sur la surface de glissement d'un substrat, et ledit nitrure de chrome ayant une structure $Cr_2N$ et une surface de glissement étant substantiellement parallèle au plan (002) de la structure $Cr_2N$,
    dans lequel le parallélisme de la surface de glissement par rapport au plan (002) de la structure $Cr_2N$, qui est spécifié par le paramètre suivant $X_{002}$ défini par l'équation suivante, tombe dans le domaine allant de 40 à 100%:

$$X_{002} = \{ ( IF_{002} - 0,103) / 0,897 \} \times 100$$

où

$$IF_{002} = I_{002} /( I_{110} + I_{002} + I_{111} + I_{112} + I_{300} + I_{113} + I_{302} + I_{221}),$$

et $I_{hkl}$ est l'intensité de diffraction aux rayons X.

2.  Organe glissant avec un film de nitrure de chrome selon la revendication 1, ledit organe glissant étant **caractérisé en ce que** ledit substrat comprend un substrat en fer et **en ce que** le film de nitrure de chrome comprend substantiellement Cr, N et C.

3.  Organe glissant avec un film de nitrure de chrome selon la revendication 2, ledit organe glissant étant **caractérisé en ce que** ledit film de nitrure de chrome comprend 5,5-17,5% en poids de N, 0,5-6,5% en poids de C, le restant étant du chrome, en tant que composants majeurs.

4.  Organe glissant avec un film de nitrure de chrome selon l'une quelconque des revendications 1 à 3, ledit organe glissant étant **caractérisé en ce que** le carbure de chrome s'insère entre ledit film de nitrure de chrome et ledit substrat d'une manière lamellaire ou d'une manière particulaire.

# FIG. 1

EP 0 972 851 B1

| ASTM POWDER DATA CARD 35−0803 | | | |
|---|---|---|---|
| hkl | d | Int | IRF hkl |
| 101 | 3.502 | 40.016194 | |
| 110 | 2.405 | 150.060729 | |
| 002 | 2.241 | 21 0.08502 | |
| 111 | 2.12 | 1000.404858 | |
| 200 | 2.083 | 10.004049 | |
| 201 | 1.888 | 10.004049 | |
| 112 | 1.64 | 190.076923 | |
| 211 | 1.486 | 10.004049 | |
| 300 | 1.389 | 150.060729 | |
| 113 | 1.169 | 730.052632 | |
| 220 | 1.202 | 10.004049 | |
| 302 | 1.18 | 100.040486 | |
| 221 | 1.161 | 100.040486 | |
| 004 | 1.12 | 20.008097 | |
| 222 | 1.059 | 30.012146 | |
| 114 | 1.076 | 20.008097 | |
| 223 | 0.937 | 40.016194 | |
| 313 | 0.914 | 10.004049 | |
| 410 | 0.909 | 10.004049 | |
| 411 | 0.891 | 80.032389 | |
| 304 | 0.872 | 60.024291 | |
| 412 | 0.802 | 40.016194 | |
| 115 | 0.84 | 50.020243 | |

$I/I_o$ vs $2\theta$, Cu K$\alpha$ — peaks labeled (110), (002), (111), (112), (300), (113), (302), (221)

# FIG . 2

EP 0 972 851 B1

# FIG . 3

○ Cr

○ N

# FIG . 4

Cr₂N

13. 5μm

SUBSTRATE
(SKD61)

SURFACE

10μm

# FIG. 5

# FIG. 6

※1 : Cr₂N PRESENT INVENTION ※5 : VANADIUM CARBIDE
※2 : Cr₂N [PVD METHOD] COMP. EX.  [MOLTEN SALT METHOD]
※3 : CrN [PVD METHOD] ※6 : CHROMIUM CARBIDE
※4 : TITANIUM NITRIDE  [CHROMIZING METHOD]
 [PVD METHOD] ※7 : HIGH SPEED TOOL STEEL,
  HEAT-TREATED

FIG . 7

# FIG. 8

7 DISK

6 PIN

# FIG. 9

BAD

PIN WEAR AMOUNT

GOOD

10

5

2

1

※1    ※2    ※3    ※4

※1 : Cr₂N  PRESENT  INVENTION
※2 : VANADIUM  CARBIDE
※3 : CHROMIUM  CARBIDE
※4 : HIGH  SPEED  TOOL  STEEL,
     HEAT-TREATED

14

# FIG . 10

# FIG. 11

■ CHROMIUM NITRIDE
□ CHROMIUM CARBIDE

FILM THICKNESS (μm)

| ※1 | SKD61 | SKD61 | SUH35 | SKD11 | Cr2N [PVD] |
|---|---|---|---|---|---|
| ※2 | 0. 4 | 0. 4 | 0. 5 | 1. 5 | ——— |
| ※3 | 1 | 4 | 4 | 4 | ——— |
| ※4 | ○ | ◎ | ◎ | ◎ | × |

※1 : SUBSTRATE
※2 : CARBON CONTENT (%)
※3 : PROCESSING TIME (h)
※4 : JUDGMENT ON ADHESION
　　　BY IMPRESSION METHOD

◎ : NO PEELING

○ : PEELING SLIGHTLY EXISTS

× : PEELING EXISTS

EP 0 972 851 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6463692 B
- JP 2129360 A
- JP 2175858 A
- JP 7189955 A
- US 2584217 A